(19) Europäisches Patentamt
European Patent Office
Office européen des brevets

(11) **EP 3 165 630 A1**

(12) **EUROPEAN PATENT APPLICATION**
published in accordance with Art. 153(4) EPC

(43) Date of publication:
**10.05.2017 Bulletin 2017/19**

(21) Application number: **15815260.3**

(22) Date of filing: **01.07.2015**

(51) Int Cl.:
*C23C 14/06* (2006.01)    *B23B 27/14* (2006.01)
*B23B 51/00* (2006.01)    *B23C 5/16* (2006.01)
*B32B 9/00* (2006.01)

(86) International application number:
**PCT/JP2015/069068**

(87) International publication number:
**WO 2016/002861 (07.01.2016 Gazette 2016/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **01.07.2014 JP 2014136030**

(71) Applicant: **Kabushiki Kaisha Kobe Seiko Sho (Kobe Steel, Ltd.)**
**Kobe-shi, Hyogo 651-8585 (JP)**

(72) Inventors:
• **NII Hiroaki**
  **Nishi-ku**
  **Kobe-shi**
  **Hyogo 651-2271 (JP)**
• **YAMAMOTO Kenji**
  **Nishi-ku**
  **Kobe-shi**
  **Hyogo 651-2271 (JP)**

(74) Representative: **Müller-Boré & Partner**
**Patentanwälte PartG mbB**
**Friedenheimer Brücke 21**
**80639 München (DE)**

(54) **HARD COATING FILM**

(57) A hard coating film that has formed therein an adhesion-reinforcing layer that comprises A layers that are composed of [Si(CN)] and B layers that are composed of [TiAl(CN)] or the like. The A layers and B layers are alternately layered upon a substrate upon a ground layer that comprises the B layer. For at least one pair of A layers that are adjacent with the B layer therebetween, the A layer that is farther from the ground layer is thicker than the A layer that is closer to the ground layer. The thickest A layer is 15 nm or more.

FIG. 1

**Description**

TECHNICAL FIELD

The present invention relates to a hard coating to be formed on a substrate surface of jigs and tools such as cutting tool and die, particularly, jigs and tools targeting a hard-to-cut material such as Carbon Fiber Reinforced Plastic (hereinafter, appropriately referred to as "CFRP").

BACKGROUND ART

It is common practice to form a hard coating on a substrate surface of jigs and tools for enhancing the wear resistance in cutting work, etc. Such a technique of forming a hard coating is disclosed in Patent Documents 1 to 5.
Patent Document 1 discloses a hard coating containing SiC. Patent Document 2 discloses a coated member having, on the surface, a hard coating applied by a sputtering method, wherein the hard coating is an SiC coating.
Patent Documents 3 and 4 disclose a coated tool having a hard coating applied to a substrate surface through an intermediate coating, wherein the intermediate coating is a nitride or carbonitride composed of $Al_xM_y$ and the hard coating is an SiC coating.
Patent Document 5 discloses a hard multilayer coating in which a layer A having a composition of $(Ti_{1-x-y}Al_xM_y)(B_aC_bN_{1-a-b-c}O_c)$ and a layer B having any composition of $B_{1-x-y}C_xN_y$, $Si_{1-x-y}C_xN_y$, $C_{1-x}N_x$ and $Cu_{1-y}(C_xN_{1-x})_y$ are stacked.

PRIOR ART LITERATURE

PATENT DOCUMENT

Patent Document 1: JP-A-2005-60765

Patent Document 2: JP-A-2012-132035

Patent Document 3: JP-A-2012-152878

Patent Document 4: JP-A-2013-96004

Patent Document 5: JP-A-2005-256080

SUMMARY OF THE INVENTION

PROBLEMS THAT THE INVENTION IS TO SOLVE

The techniques disclosed in Patent Documents 1 to 2 are configured to form an SiC coating on a substrate surface, but the adhesion between the substrate surface and the SiC coating is insufficient.
The techniques disclosed in Patent Documents 3 and 4 are configured to form a hard coating composed of SiC on an intermediate coating composed of AlxMy, but the adhesion at the interface between $Al_xM_y$ and SiC is insufficient.
Thus, due to low adhesion of the substrate or each coating, the techniques disclosed in Patent Documents 1 o 4 can hardly be practical as a hard coating used for jigs and tools.
In the technique disclosed in Patent Document 5, the composition, etc. of the hard multilayer coating are specified to exert the effect of enhancing the wear resistance or oxidation resistance, but there is room for improvement in terms of enhancing the adhesion between the hard multilayer coating and the substrate.
Furthermore, during cutting work targeting a hard-to-cut material, particularly, CFPR, wear of jigs and tools during cutting work becomes serious due to bad workability of a carbon fiber in CFPR. Accordingly, high hardness and excellent wear resistance are required of a hard coating of jigs and tools used for cutting work of CFRP.
The present invention has been made in consideration of these circumstances, and an object of the present invention is to provide a hard coating that is formed on a substrate surface of jigs and tools, has high hardness, and is excellent in adhesion and wear resistance.

MEANS FOR SOLVING THE PROBLEMS

The hard coating in the present invention which solves the above problems is directed to a hard coating to be formed on a substrate, the hard coating comprising:

a layer A having a composition of $Si_w(C_xN_{1-x})_{1-w}$ and satisfying

$$0.30 \leq w \leq 0.65,$$

and

$$0.3 \leq x \leq 0.7;$$

and

a layer B having a composition of any of $Ti_{1-a}Al_a(C_{1-k}N_k)$, $Al_bCr_{1-b}(C_{1-k}N_k)$, $Ti_{1-c-d-e}Cr_cAl_dSi_e(C_{1-k}N_k)$ and $Ti_{1-f}Si_f(C_{1-k}N_k)$ and satisfying

$$0.3 \leq a \leq 0.7,$$

$$0.3 \leq b \leq 0.8,$$

$$c \leq 0.3,$$

$$0.3 \leq d \leq 0.7,$$

$$0 \leq e \leq 0.3,$$

$$1-c-d-e \leq 0.3,$$

$$0.05 \leq f \leq 0.3,$$

and

$$0.5 \leq k \leq 1,$$

wherein an underlying layer composed of the layer B is formed on the substrate, and an adhesion-reinforcing layer in which the layer A and the layer B have been alternately and repeatedly stacked is formed on the underlying layer, at least one pair of layers A adjoining each other through a layer B within the adhesion-reinforcing layer satisfy the relationship that the thickness of the layer A formed on the side farther from the underlying layer is larger than the thickness of the layer A formed on the side closer to the underlying layer, and
the maximum thickness of the layer A within the adhesion-reinforcing layer is 15 nm or more.

Thus, the hard coating according to the present invention includes a layer A and a layer B each having a predetermined composition by alternately stacking the layers, whereby the hardness of the hard coating is high and the wear resistance of the hard coating is enhanced. The hard coating includes an underlying layer composed of the layer B, whereby the adhesion between the coating and the substrate is enhanced. The hard coating includes an adhesion-enhancing layer in which the layer A and the layer B have been alternately and repeatedly stacked, and not only at least one pair of layers A satisfy a predetermined relationship but also the maximum thickness of the layer A is not less than a predetermined thickness, whereby the adhesion and wear resistance of the hard coating are enhanced.

Since CFPR as a cutting work object in the present invention has a low thermal conductivity, heat is likely to be accumulated in jigs and tools during cutting work of CFRP, readily providing a high temperature. Accordingly, heat resistance or oxidation resistance is required of the hard coating of jigs and tools used for cutting work of CFRP.

Here, the layer A in the adhesion-reinforcing layer of the hard coating according to the present invention has heat resistance, high hardness and excellent wear resistance. In addition, the layer B in the adhesion-reinforcing layer is excellent in oxidation resistance and toughness. Thus, the hard coating according to the present invention has a layer A excellent in heat resistance and a layer B excellent in oxidation resistance, so that the cutting work can be suitably performed even when a hard-to-cut material such as CFPR is a cutting work object.

In the hard coating according to the present invention, it is preferred that a layer C is further formed on the adhesion-reinforcing layer, the layer C has a composition of SiC, and the thickness of the layer C is 0.2 $\mu$m or more and 5.5 $\mu$m or less.

Thus, in the hard coating according to the present invention, a layer C is further formed on the adhesion-reinforcing layer and the layer C has a composition of SiC and has a predetermined thickness, so that the wear resistance of the hard coating can be further enhanced.

ADVANTAGE OF THE INVENTION

According to the hard coating of the present invention, a layer A and a layer B each has a predetermined composition, an underlying layer composed of the layer B and an adhesion-reinforcing layer in which the layer A and the layer B have been stacked are provided, the thickness of the layer A satisfies a predetermined requirement, and a hard coating having high hardness and excellent in adhesion and wear resistance is therefore provided.

BRIEF DESCRIPTION OF THE DRAWINGS

[FIG. 1] A cross-sectional view illustrating a first embodiment of the hard coating according to the present invention.
[FIG. 2] A cross-sectional view for schematically illustrating and explaining the state of grains in the hard coating according to the present invention.
[FIG. 3] A cross-sectional view illustrating a second embodiment of the hard coating according to the present invention.
[FIG. 4] A schematic configuration diagram illustrating a deposition apparatus.

MODE FOR CARRYING OUT THE INVENTION

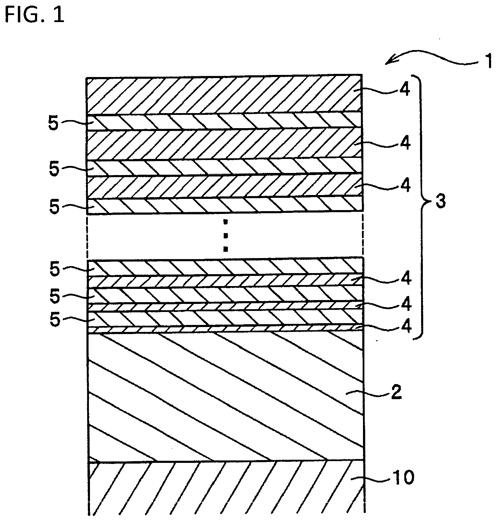

A first embodiment of the hard coating according to the present invention is described by referring to the drawings.
As illustrated in FIG. 1, the hard coating 1 is a coating to be formed on a substrate 10 for enhancing the adhesion, hardness and wear resistance and has an underlying layer 2 and an adhesion-reinforcing layer 3 formed on the underlying layer 2.

<Substrate>

Examples of the substrate 10 include cemented carbide, metal carbide-containing iron-based alloy, cermet, a high-speed tool steel, etc. However, the substrate 10 is not limited thereto and may be a cutting tool such as tip, drill or end mill, or jigs and tools such as pressing die, forging die, forming die or blanking punch.

<Underlying Layer>

The underlying layer 2 is a coating to be formed on the substrate 10 and is composed of a layer B having a predetermined composition. By forming the underlying layer 2, the adhesion between the substrate 10 and the hard coating 1 is enhanced. Accordingly, the thickness of the underlying layer 2 is preferably from 0.1 to 5 $\mu$m. Details of the composition of the layer B are described later.

<Adhesion-Reinforcing Layer>

The adhesion-reinforcing layer 3 is a coating formed on the underlying layer 2 and is formed by alternately and repeatedly stacking a layer A 4 having a predetermined composition and a layer B 5 having a predetermined composition.

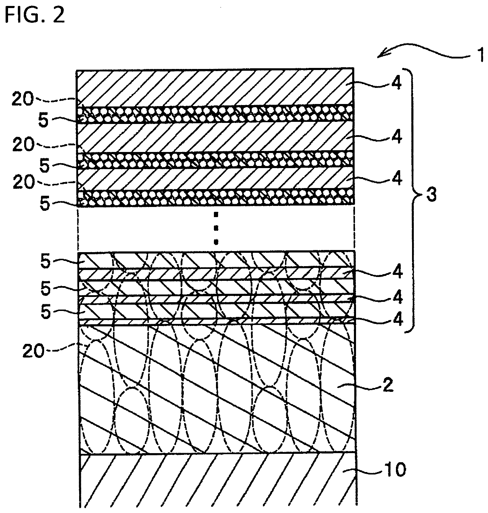

First, how the present inventors have specified the configuration of the adhesion-reinforcing layer 3 is described by referring to FIGs. 1 and 2.

The layer A 4 in the adhesion-reinforcing layer 3 is a coating having heat resistance, high hardness and excellent wear resistance, but if the layer is used as a single layer, due to a problem in adhesion to the substrate 10, further enhancement of the wear resistance encounters a problem. On the other hand, the layer B 5 in the adhesion-reinforcing layer 3 is a coating excellent in oxidation resistance, and also excellent in resistant to deformation thanks to its high toughness, but if the layer is used alone, the wear resistance is disadvantageously inferior to the layer A 4.

Furthermore, as illustrated in FIG. 2, in the underlying layer 2 composed of the layer B, a coarse columnar grain 20 having a major diameter of 0.1 to 2.0 $\mu$m grows unidirectionally toward a direction perpendicular to the substrate 10 surface, in other words, toward a direction distanced from the substrate 10 surface. Accordingly, there is a problem that despite an attempt to form a layer such as SiC on the surface of the underlying layer 2, alignment of crystal orientation and in turn, adhesion of two layers are poor.

As a result of intensive studies to solve these problems, the present inventors have found that when a layer A 4 and a layer B 5 are alternately and repeatedly stacked as an adhesion-reinforcing layer 3 on/above the underlying layer 2 and the layer A 4 is formed to satisfy a predetermined thickness requirement, the unidirectional growth of a coarse grain 20 in the underlying layer 2 and in the layer B 5 of the underlying layer 2 side within the adhesion-reinforcing layer 3 can be suppressed. It has also been found that when at least one pair of layers A 4 and 4 adjoining each other through a layer B 5 within the adhesion-reinforcing layer 3 satisfy the relationship that the thickness of a layer A 4 formed on the side farther from the underlying layer 2 is larger than the thickness of a layer A 4 formed on the side closer to the underlying layer 2, the unidirectional growth and effect of a coarse grain 20 can be gradually weakened as it goes toward the hard coating 1 surface side and the grain 20 in the layer B 5 can be refined.

Consequently, the grain 20 in the layer B 5 within the adhesion-reinforcing layer 3 is gradually refined as it goes toward the hard coating 1 surface side and since misalignment at the interface between the layer A 4 and the layer B 5 hardly occurs, the adhesion is enhanced. In addition, the grain 20 in the layer B 5 on the outermost surface is sufficiently refined, and during the formation of the later-described layer C on the adhesion-reinforcing layer 3, the adhesion of both layers is also enhanced. Furthermore, by stacking a layer A 4 and a layer B 5 as the adhesion-reinforcing layer 3, the above-described effect of the layer A 4 and the layer B 5 can be naturally exerted.

(Thickness of Each Layer Constituting Adhesion-Reinforcing Layer)

In order to bring out the above-described effect of enhancing the adhesion, at least one pair of layers A 4 and 4 adjoining each other through a layer B 5 within the adhesion-reinforcing layer 3 (hereinafter, simply referred to as "at least one pair of layers A") must satisfy the relationship that the thickness of a layer A 4 formed on the side farther from the underlying layer 2 is larger than the thickness of a layer A 4 formed on the side closer to the underlying layer 2. More specifically, at least one pair of layers A 4 and 4 need to satisfy the relationship of "thickness of layer A 4 formed on the side closer to underlying layer 2" < "thickness of layer A 4 formed on the side father from underlying layer 2".

Since it is sufficient if at least one pair of layers A 4 and 4 satisfy the relationship above, other layers A 4 may have a constant thickness, or there may be a portion where the thickness of a layer A 4 on the side closer to the underlying layer 2 is larger than the thickness of a layer A 4 farther from the underlayer 2.

However, in order to unfailingly achieve the effect of enhancing the adhesion, the layer A 4 preferably has a configuration that the thickness stepwise increases as it goes distant from the underlying layer 2 (i.e., as it goes close to the hard coating 1 surface). For example, a configuration where the thickness of the layer A 4 is increased by 0.1 to 20 nm with every stacking (every one layer or every two or more layers) is preferred.

In addition, in order to bring out the above-described effect of enhancing the adhesion, a function of preventing coarsening of a grain 20 in the layer B 5 within the adhesion-reinforcing layer 3 needs to be imparted to the layer A 4 and for this reason, the maximum thickness of the layer A 4 within the adhesion-reinforcing layer 3 must be 15 nm or more. In other words, the maximum thickness of a thickest layer A 4 within the adhesion-reinforcing layer 3 must be 15 nm or more.

By forming a layer A 4 having a maximum thickness of 15 nm or more, the layer A 4 can prevent coarsening of a grain 20 in the underlying layer 2 as well as in the layer B 5 within the adhesion-reinforcing layer 3 and enhance the adhesion. In order to more unfailingly achieve the effect of enhancing adhesion, the maximum thickness of the layer A 4 is preferably 20 nm or more. On the other hand, the upper limit of the maximum thickness of the layer A 4 is not particularly limited but in view of ease of implementation of deposition and cost, the maximum thickness is preferably 60 nm or less, more preferably 55 nm or less.

From the viewpoint of profitability such as reduction of deposition time, based on the outermost surface (surface on the side father from the underlying layer 2) of the adhesion-reinforcing layer 3, the layer A 4 having a maximum thickness is preferably formed in a region up to 50% of the thickness of the entire adhesion-reinforcing layer 3, more preferably formed in a region up to 30% of the thickness of the entire adhesion-reinforcing layer 3.

The minimum thickness of the layer A 4 is not particularly limited but is preferably from 0.1 to 20 nm.

As for the layer B 5 within the adhesion-reinforcing layer 3, the thickness of each layer B 5 is preferably constant. The thickness of each layer B is preferably from 5 to 100 nm, more preferably from 10 to 60 nm.

The thickness of the adhesion-reinforcing layer 3, i.e., the total thickness of layers A 4 and layers B 5 stacked, is preferably from 0.5 to 10 $\mu$m.

In the adhesion-reinforcing layer 3, it is preferred that the layer A 4 and the layer B 5 are stacked, with the layer A 4 on the substrate 10 side, and the layer on the outermost surface side is a layer A 4. However, although not shown, the layer on the outermost surface layer side of the adhesion-reinforcing layer 3 may be a layer B 5.

The number of layers of each of the layer A 4 and the layer B 5 constituting the adhesion-reinforcing layer 3 is not particularly limited but is preferably from 10 to 200.

Here, the thickness of each of the underlying layer 2 and the adhesion-reinforcing layer 3 (layer A 4 and layer B 5) can be controlled by evaporation amount, etc. of a target during the production described later of the hard coating 1.

(Composition of Layer A)

The composition of the layer A 4 is composed of a metal component (Si) and nonmetal components (C, N).

The layer A 4 is a coating having a composition of $Si_w(C,N)_{1-w}$ and satisfying $0.30 \leq w \leq 0.65$.

The metal component Si is an element added so as to impart high hardness and wear resistance to the layer A. In order to exert these effects, the atomic ratio (w) of Si must be from 0.30 to 0.65 and is preferably from 0.35 to 0.65.

The layer A 4 is a coating in which the atomic ratio of nonmetallic components is $(C_x N_{1-x})$ and satisfies $0.3 \leq x \leq 0.7$ and $(0.3 \leq 1-x \leq 0.7)$.

The nonmetal component C is an element contributing to higher hardness of the layer A. However, in order to avoid reduction in the adhesion due to too large C content, the atomic ratio (x) of C must be from 0.3 to 0.7 and is preferably from 0.35 to 0.65.

The atomic ratio (1-x) of N must be from 0.3 to 07 so as to ensure wear resistance and adhesion and is preferably from 0.35 to 0.65.

(Composition of Layer B)

The composition of the layer B 5 is composed of metal components (Ti, Al, Cr, Si) and nonmetal components (C, N), and this layer is any of the following four kinds of coatings.

(1) Coating having a composition of $Ti_{1-a}Al_a(C_{1-k}N_k)$ and satisfying $0.3 \leq a \leq 0.7$ and $0.5 \leq k \leq 1$

In order for the layer B 5 to have high hardness and wear resistance and be excellent in adhesion, the atomic ratio (1-a) of the metal component Ti must be from 0.3 to 0.7, and the atomic ratio (a) of the metal component Al must be from 0.3 to 0.7. In addition, in order for the layer B 5 to have high hardness and wear resistance and be excellent in adhesion, at least the atomic ratio (k) of nonmetal component N must be from 0.5 to 1. Furthermore, in order to impart higher hardness to the layer B 5, the atomic ratio (1-k) of nonmetal component C may be 0.5 or less.

(2) Coating having a composition of $Al_bCr_{1-b}(C_{1-k}N_k)$ and satisfying $0.3 \leq b \leq 0.8$ and $0.5 \leq k \leq 1$

In order for the layer B 5 to have high hardness and wear resistance and be excellent in adhesion, the atomic ratio (b) of the metal component Al must be from 0.3 to 0.8, and the atomic ratio (1-b) of the metal component Cr must be from 0.2 to 0.7. In addition, in order for the layer B 5 to have high hardness and wear resistance and be excellent in adhesion, at least the atomic ratio (k) of nonmetal component N must be from 0.5 to 1. Furthermore, in order to impart higher hardness to the layer B 5, the atomic ratio (1-k) of nonmetal component C may be 0.5 or less.

(3) Coating having a composition of $Ti_{1-c-d-e}Cr_cAl_dSi_e(C_{1-k}N_k)$ and satisfying $c \leq 0.3$, $0.3 \leq d \leq 0.7$, $0 \leq e \leq 0.3$, $1-c-d-e \leq 0.3$ and $0.5 \leq k \leq 1$

In order for the layer B 5 to have high hardness and wear resistance and be excellent in adhesion, at least the atomic ratio (1-c-d-e) of the metal component Ti must be 0.3 or less, at least the atomic ratio (c) of the metal component Cr must be 0.3 or less, at least the atomic ratio (d) of the metal component Al must be from 0.3 to 0.7 and at least the atomic ratio (e) of metal component Si must be 0.3 or less. In addition, in order for the layer B 5 to have high hardness and wear resistance and be excellent in adhesion, at least the atomic ratio (k) of nonmetal component N must be from 0.5 to 1. Furthermore, in order to impart higher hardness to the layer B 5, the atomic ratio (1-k) of nonmetal component C may be 0.5 or less.

(4) Coating having a composition of $Ti_{1-f}Si_f(C_{1-k}N_k)$ and satisfying $0.05 \leq f \leq 0.3$ and $0.5 \leq k \leq 1$

In order for the layer B 5 to have high hardness and wear resistance and be excellent in adhesion, the atomic ratio (1-f) of the metal component Ti must be from 0.7 to 0.95 and the atomic ratio (f) of metal component Si must be from 0.05 to 0.3. In addition, in order for the layer B 5 to have high hardness and wear resistance and be excellent in adhesion, at least the atomic ratio (k) of nonmetal component N must be from 0.5 to 1. Furthermore, in order to impart higher hardness to the layer B 5, the atomic ratio (1-k) of nonmetal component C may be 0.5 or less.

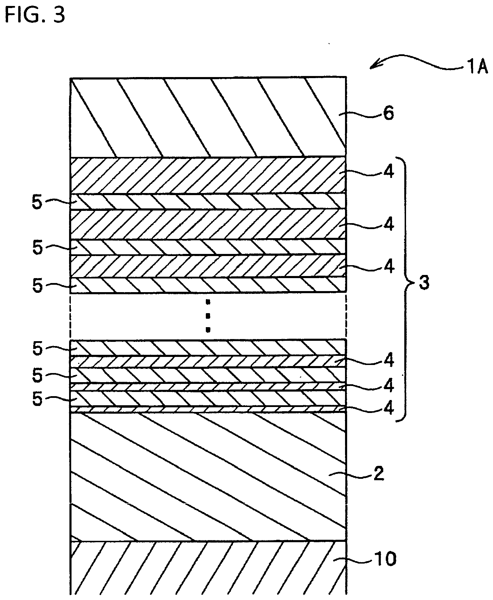

The atomic ratios (w, x, a, b, c, d, e, f, k) of Si, C, N, Ti, Al and Cr in the underlying layer 2, layer A 4 and layer B 5 are controlled by the composition of a target set in a deposition apparatus 100 (see, FIG. 3) during the production described later of the hard coating 1 (coating forming step). The atomic ratios (x, k) of C and N may be controlled by the introduction amount of an inert gas, such as nitrogen or hydrocarbon, introduced into the deposition apparatus 100. The thicknesses of the underlayer 2, layer A 4 and layer B 5 are controlled by the evaporation amount, etc. of the target during the formation of coating.

A second embodiment of the hard coating according to the present invention is described by referring to the drawings.

As illustrated in FIG. 3, the hard coating 1A includes an underlying layer 2, an adhesion-reinforcing layer 3 composed of a layer A 4 and a layer B 5, and a layer C 6 formed on the adhesion-reinforcing layer 3. The wear resistance of the hard coating 1 A is more enhanced by providing a layer C 6.

The underlying layer 2 and the adhesion-reinforcing layer 3 composed of a layer A 4 and a layer B 5 are identical to those in the hard coating 1 of the first embodiment, and a description of the same is omitted.

(Composition of Layer C)

The composition of the layer C 6 is composed of SiC.

Here, the layer C 6 having a composition of SiC and the layer A 4 having a composition of $Si_w(C_xN_{1-x})_{1-w}$ of the adhesion-reinforcing layer 3 contain the same element and therefore, the affinity between both layers is high. In addition, as to the layer C 6 and the layer B 5 of the adhesion-reinforcing layer 3, since the grain 20 of the layer B 5 is refined, crystal orientations of SiC of the layer B 5 and the layer C 6 are likely to be aligned.

Consequently, the layer C 6 can be formed in the state of exhibiting good adhesion to both the layer A 4 and the layer B 5 of the adhesion-reinforcing layer 3.

If the layer C formed on the outermost surface is too thick, fracture (chipping) of the layer readily occurs due to internal stress, resulting in the reduction of adhesion of the hard coating 1A. For this reason, the thickness of the layer C is 5.5 $\mu$m or less, preferably 4.0 $\mu$m or less, more preferably less than 4.0 $\mu$m. In addition, in order to ensure wear resistance, the thickness of the layer C is 0.2 $\mu$m or more, preferably 0.25 $\mu$m or more, more preferably 0.5 $\mu$m or more.

The thickness of the layer C 6 can be controlled by the evaporation amount, etc. of a target during the production described later of the hard coating 1A.

A first method for forming the hard coating according to the present invention, i.e., the method for forming the hard coating of the first embodiment, is described below. As for the configuration of the hard coating 1, FIG. 1 is referred to.

The method for forming the hard coating 1 includes a substrate preparing step, a substrate heating step, and a coating forming step.

(Substrate Preparing Step)

The substrate preparing step is a step of preparing a substrate 10 having a predetermined size, if desired, by cleaning it with an ultrasonic wave, etc.

(Substrate Heating Step)

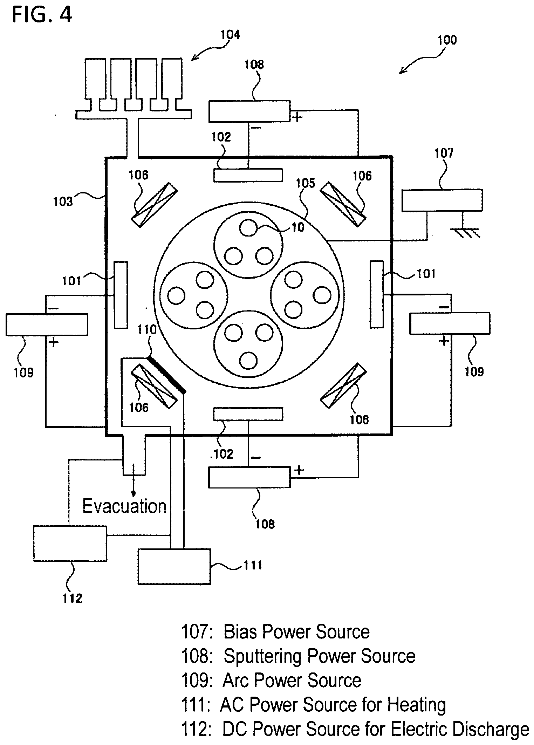

The substrate heating step is a step of introducing the substrate 10 into a deposition apparatus 100 illustrated in FIG. 4 and then heating it, and the substrate 10 is preferably heated so that it can be kept at a predetermined temperature, for example, at 500 to 550°C. Heating the substrate 10 facilitates forming a hard coating 1 on the substrate 10 in the next step.

(Coating Forming Step)

The coating forming step is a step of forming a hard coating I on the substrate 10 by using at least either one of an arc ion plating method (AIP method) and a sputtering method (SP method). Specifically, an underlying layer 2 is formed on the substrate 10 by an AIP method or an SP method, and an adhesion-reinforcing layer 3 is formed on the underlying layer 2 by using an SP method or both an AIP method and an SP method. The layer A 4 in the adhesion-reinforcing layer 3 is formed by an SP method, and the layer B 5 in the adhesion-reinforcing layer 3 is formed by an AIP method or an SP method. In the case of forming the layer A 4 by an SP method, a bias voltage of -200 V or more and less than 0 V is preferably applied to the substrate 10.

In addition to the above-described steps, the method for forming the hard coating 1 of the present invention may include a substrate etching step between the substrate heating step and the coating forming step. The substrate etching step is a step of etching a surface of the substrate 10 with an ion of a rare gas such as Ar.

As an example of the method for forming the hard coating 1, the case using a deposition apparatus 100 illustrated in FIG. 4 is described below. The deposition apparatus is not limited thereto.

As illustrated in FIG. 4, the deposition apparatus 100 includes a chamber 103 having an exhaust port for evacuation and a gas supply port 104 of supplying a deposition gas and a rare gas, an arc power source 109 connected to an arc evaporation source 101, a sputtering power source 108 connected to a sputtering evaporation source 102, a substrate stage 105 of supporting a substrate 10 as a deposition object, and a bias power source 107 of applying a negative bias voltage to the substrate 10 between the substrate stage 105 and the chamber 103 through the substrate stage 105. In addition, the apparatus includes a heater 106, a direct-current power source 112 for electric discharge, an ac power source 111 for heating a filament, etc.

First, a target (not shown) for underlying layer, composed of various meals, alloys or metal compounds, is attached to the arc evaporation source 101 or sputtering evaporation source 102 of the deposition apparatus 100, a substrate 10 is attached on the substrate stage 105, and the inside of the chamber 103 is vacuumed (for example, evacuated to $5 \times 10^{-3}$ Pa or less) to form a vacuum state. Thereafter, Ar as a rare gas is introduced into the chamber 103, the substrate 10 is heated at a predetermined temperature by the heater 106 inside the chamber 103, and etching with an Ar ion in an ion source produced through thermionic emission from the filament 110 is performed for a predetermined time.

Next, while introducing, if desired, a deposition gas (e.g., $N_2$, hydrocarbon) into the chamber 103, the target for underlying layer is evaporated by the arc power source 109 or the sputtering power source 108, and the substrate stage 105 supporting the substrate 10 is rotated to form an underlying layer 2 with a predetermined thickness on the substrate 10. Here, the thickness of the underlying layer 2 is controlled by the input power to the arc evaporation source 101 or sputtering evaporation source 102 (the evaporation amount of the target for underlying layer) or the rotational speed or the number of revolutions of the substrate stage 105. As the rotational speed of the substrate stage 105 is higher, the thickness of the underlying layer 2 is smaller.

Subsequently, a target (not shown) for layer A, composed of various meals, alloys or metal compounds, is attached to the sputtering evaporation source 102, and a target (not shown) for layer B, composed of various meals, alloys or metal compounds, is attached to the sputtering evaporation source 102 or arc evaporation source 101. While introducing, if desired, a deposition gas into the chamber 103, the target for layer A and the target for layer B are simultaneously evaporated by the sputtering power source 108 or by the sputtering power source 108 and the arc power source 109. At this time, the substrate stage 105 supporting the substrate 10 (object to be treated) having formed thereon the underlying layer 2 is rotated, whereby an adhesion-reinforcing layer 3 in which the layer A 4 and the layer B 3 have been alternately stacked is formed on the underlying layer. The layer A 4 within the adhesion-reinforcing layer 3 is formed to increase in the thickness with every stacking.

The object to be treated passes alternately the evaporation sources having attached thereto targets differing in the composition as the substrate stage 105 is rotated. Coatings corresponding to target compositions of respective evaporation sources are here formed alternately, whereby an adhesion-reinforcing layer 3 in which the layer A 4 and the layer B 5 have been alternately stacked can be formed. The thickness of each of the layer A 4 and the layer B 5 and the amount of increase in thickness of the layer A 4 are controlled by the input power to each evaporation source (the evaporation amount of the target) or the rotational speed or the number of revolutions of the substrate stage 105. As the rotational speed of the substrate stage 105 is higher, the thickness per one layer is smaller. The evaporation of the target for layer A and the target for layer B is not limited to simultaneous evaporation, and evaporation of the target for layer B may be performed after the layer A is formed.

During the formation of the layer A, it is preferable to apply a bias voltage of -200 V or more and less than 0 V, preferably -150V or more and -10 V or less, to the substrate 10 (the substrate 10 on which the underlying layer 2 has been formed) through the substrate stage 105 from a bias power source 107. By applying a bias voltage in a predetermined range to the substrate 10, the cutting performance of the hard coating is enhanced to increase the wear resistance. Increase in the negative voltage of the bias voltage brings about heating of the substrate 10 during deposition or reduction in the deposition rate, and the layer A is therefore not uniformly deposited, as a result, it is likely that fracture (chipping) occurs in the hard coating 1 during cutting and the wear resistance decreases.

As for the sputtering power source 108 used for forming the layer A, a UBMS power source (normal power source) such as UBMS202 manufactured by Kobe Steel, Ltd., a DMS power source, etc. can be used. The sputtering power source 108 is preferably a DMS power source. By using a DMS power source as the sputtering power source 108, the hardness and wear resistance can be more enhanced than in the case of using a normal power source (UBMS power source). When a DMS power source is used, the hardness is considered to rise because the ion irradiation dose of the target for layer A is increased by the DMS power source.

A second method for forming the hard coating according to the present invention, i.e., the method for forming the hard coating of the second embodiment, is described below. As for the configuration of the hard coating 1A, FIG. 2 is referred to.

The method for forming the hard coating 1A includes a substrate preparing step, a substrate heating step, and a coating forming step. The substrate preparing step and the substrate heating step are identical to those in the first forming method above (the method for forming the hard coating 1 illustrated in FIG. 1), and a description of the same is omitted. The method for forming the hard coating 1A may include the above-described substrate etching step between the substrate heating step and the coating forming step.

(Coating Forming Step)

The coating forming step is a step of forming, on/above the substrate 10, an underlying layer 2 and an adhesion-reinforcing layer 3 composed of a layer A 4 and a layer B 5 in the same manner as in the first forming method, and then forming a layer C 6 on the adhesion-reinforcing layer 3 by an SP method or an AIP method. In the case of forming the layer C 6 by an SP method, a UBMS power source, a DMS power source, etc. is used as the sputtering power source, and a DMS power source is preferably used. At the time of formation of the layer C, a bias voltage is preferably applied to the substrate 10. During forming the layer C 6 by an SP method, it is preferable to apply a bias voltage of -100 V or more and less than 0 V to the substrate 10 when a DMS power source is used, and apply a bias voltage of -150 V or more and less than 0 V to the substrate 10 when an UBMS power source is used.

In the method for forming the layer C 6 in the deposition apparatus 100 of FIG. 4, a target for layer C, composed of SiC, is attached to the sputtering evaporation source 102 and while evaporating the target for layer C by the sputtering power source 108, the substrate stage 105 supporting the substrate 10 (object to be treated) on/above which the underlayer 2 and the adhesion-reinforcing layer 3 have been formed is rotated to form a layer C 6 with a predetermined thickness on the adhesion-reinforcing layer 3 of the object to be treated. The thickness of the layer C 6 is controlled by the input power to the sputtering power source 108 (the evaporation amount of the target for layer C) or the rotational speed or the number of revolutions of the substrate stage 105. As the rotational speed of the substrate stage 105 is higher, the thickness per the layer C 6 is smaller.

During the formation of the layer C, in the case of a DMS power source, a bias voltage of -100 V or more and less than 0 V, preferably -100 V or more and less than -10 V, more preferably -90 V or more and less than -20 V, and in the case of a UBMS power source, a bias voltage of -150 V or more and less than 0 V,
preferably -120 or more and less than -20 V, is preferably applied to the substrate 10 (the substrate 10 on/above which the underlying layer 2 and the adhesion-reinforcing layer 3 have been formed) through the substrate stage 105 from a bias power source 107.

By applying a bias voltage in a predetermined range to the substrate 10, the hardness and wear resistance of the hard coating 1A are enhanced. If the negative voltage of the bias voltage becomes large, the hardness of the layer C 6 may be increased, but heating of the substrate 10 during deposition or reduction in the deposition rate is caused, and the layer C 6 is therefore not uniformly deposited, as a result, it is likely that fracture (chipping) occurs in the hard coating 1A during cutting and the wear resistance decreases. When a bias voltage is applied, the hardness is considered to rise because a large potential difference is generated between the target for layer C and the substrate 10 and in turn, the ion irradiation dose of the target for layer C is increased.

EXAMPLES

In the following, Examples according to the present invention are described. In Examples, a hard coating was formed using the deposition apparatus illustrated in FIG. 4. The present invention is not limited to the following Examples.

<First Example>

In First Example, both the layer A and the layer B were deposited by varying the composition. An underlying layer composed of a layer B was deposited to have a thickness of 0.5 μm, and an adhesion-reinforcing layer was then deposited to have a thickness of 1.5 μm. For the deposition of the layer A within the adhesion-reinforcing layer, a UBMS power source or a DMS power source was used. The deposition was performed by fixing the bias voltage to -75 V during the deposition of the layer A. Layers A and B differing in the composition were formed and by changing the thickness of the layer A within the adhesion-reinforcing layer, the effect on the hardness, adhesion and wear resistance was studied.

As Comparative Examples, coatings in which a single layer of layer A or underlying layer (layer B) was formed to have a thickness of 2.0 $\mu$m (Nos. 8, 24, 35 and 43) were prepared. In addition, a coating in which an underlying layer (layer B) was formed to have a thickness of 0.5 $\mu$m and an adhesion-reinforcing layer composed of only a layer A was then formed to have a thickness of 1.5 $\mu$m (No. 25) was prepared.

Specifically, as the substrate, a cutting tool (drill) and a mirror-finished carbide specimen (13 mm square x 5 mm thickness) were ultrasonically cleaned in ethanol, and the substrate was attached on the substrate stage. The inside of the deposition apparatus was evacuated to $5 \times 10^{-3}$ Pa and after heating the substrate up to 500°C, etching with Ar ion was conducted for 5 minutes. Thereafter, a nitrogen gas or, if desired, a mixed gas prepared by adding a carbon-containing gas to a nitrogen gas, was introduced to 4 Pa, a layer B target (target diameter: 100 mm$\phi$) was attached to the arc evaporation source, the arc evaporation source was operated at a discharge current of 150 A, and the substrate stage was rotated at a rotational speed of 5 rpm to form an underlying layer.

Next, a layer A target (target diameter: 152.4 mm$\phi$) was attached to the sputtering evaporation source, a layer B target (the same as the underlying layer target) was attached to the arc evaporation source, and the substrate stage was rotated at a rotational speed of 5 rpm. Firstly, only the layer A target was evaporated alone for a short time in the above-described predetermined atmosphere such as nitrogen gas, and a bias voltage of -75 V was applied to the substrate to form a layer A (lowermost layer) with a predetermined thickness. Thereafter, an Ar gas was introduced, the layer B target was evaporated, the layer A target and the layer B target were simultaneously evaporated, and the substrate stage was rotated at a rotational speed of 5 rpm while applying a bias voltage of -75 V to the substrate, whereby an adhesion-reinforcing layer in which the layer A and the layer B had been alternately stacked was formed on the underlying layer so as to have a total thickness of 1.5 $\mu$m. The minimum thickness (thickness of the lowermost layer), the amount of increase in the thickness (the amount of increase in the layer A thickness increasing every one layer as it goes from the lowermost layer toward the uppermost layer), and the maximum thickness (thickness of uppermost layer), of the layer A, and the thickness of the layer B (thickness of one layer) were set as shown in Tables 1 to 4.

After the deposition, the component composition in the hard coating was measured, and the hardness, adhesion and wear resistance were evaluated. The results obtained are shown in Tables 1 to 4.

In the Tables, "Presence or Absence of Layers A (Pair) in Predetermined Relationship" displays whether as to a pair (two layers A) satisfying the relationship that out of a pair of layers A adjoining each other through a layer B, the thickness of a layer A formed on the side farther from the underlying layer is larger than the thickness of a layer A formed on the side closer to the underlying layer, one or more pairs are present, and "A" indicates that one or more pairs are present.

(Component Composition)

The component compositions of the underlying layer and the adhesion-reinforcing layer composed of the layer A and the layer B were measured by EPMA (Electron Probe Micro analyzer).

(Measurement of Maximum Thickness of Layer A)

As for the maximum thickness of the layer A, a carbide specimen having formed thereon a hard coating was worked by the following "sample manufacture apparatus" and then measured for the thickness by the following "observation apparatus".

[Processing of Sample]

Sample manufacturing apparatus:

Focused ion beam processing apparatus, FB2000A, manufactured by Hitachi, Ltd.

High-performance ion microscope, SMI9200, manufactured by SII NanoTechnology Inc.

Accelerating voltage: 30 kV (FIB normal processing)
Ion source: Ga

Manufacturing method:

The carbide specimen was processed by the FIB method (focused ion beam processing method). For the protection of the outermost surface of the specimen, after coating with a carbon film by a high-vacuum evaporation apparatus and FIB, a small test piece was extracted by FIB microsampling. The extracted small piece was then sectioned by FIB processing to a thickness allowing observation by a transmission electron microscope (TEM).

[Measurement of Thickness]

    Apparatus used for observation: Transmission electron microscope, H-800, manufactured by Hitachi, Ltd.
    Accelerating voltage: 200 kV
    Photographing magnification: 200,000 times
    Overall magnification: 300,000 times

Evaluation conditions:

An arbitrary one visual field (cross-section) was photographed as an under-focused image, the pertinent one layer was measured at 10 points at equal intervals on the photographed image, and the average value of 8 points excluding the minimum value and the maximum value was defined as the film thickness of the one layer. The maximum thickness of the layer A within the adhesion-reinforcing layer was measured by this method. The thickness of the layer B was also measured by the same method.

With respect to the amount of increase in the thickness of the layer A, the thickness of a layer A located in the lower part of arbitrary one visual field (cross-section) and the thickness of a layer A located in the upper part were measured (the measuring method was in conformity with above), and the difference therebetween was divided by the number of layers A located in the lower and upper parts to calculate an increment per one layer.

The minimum thickness of the layer A was estimated from the measurable minimum measurement limit thickness of the layer A. In the estimation method, the difference between the position of the top of the underlying layer calculated from the deposition rate of the underlying layer B and the position of the minimum measurement limit thickness of the layer A was determined, and assuming that a layer A and a layer B were alternately formed in a region corresponding to this difference, the minimum thickness of the layer A was estimated by taking into account the increment of the layer A calculated above.

The thickness was shown as 0.1 nm when the amount of increase in the thickness of layer A and the minimum thickness of layer A, determined by these methods, were 0.1 nm or less.

(Hardness)

The hardness was measured by a nanoindenter test using a carbide specimen having formed thereon a hard coating. In the measurement using a nanoindenter, "ENT1100 manufactured by Elionix Inc." was used as the apparatus, and a Berkovich type triangular pyramid indenter was used as the indenter. Initially, a load strain curve was measured at 5 points under each of 5 loads, i.e., loads of 2, 5, 7, 10, and 20 mN. Subsequently, the data were corrected on the basis of the compliance of apparatus by the method proposed by SAWA, et al. of calibrating the indenter tip shape (J. Mater. Res., Vol. 16, No. 11, 2001, 3084). A hardness of 30 GPa or more was rated as good, and a hardness of less than 30 GPa was rated as poor.

(Adhesion)

The adhesion was evaluated by a scratch test using a carbide specimen having formed thereon a hard coating. The scratch test was performed by moving a diamond indenter of 200 $\mu$mR on the hard coating under the conditions of a load increasing rate of 100 N/min and an indenter moving speed of 10 mm/min. As for the critical load value, after the scratch test, the scratched part was observed by an optical microscope, and the load value in the portion where a damage occurred in the coating was employed as the critical load value. This critical load value is shown as Adhesion (N) in Tables 1 to 5. The adhesion was rated as good when the adhesive force was 75 N or more, and the adhesion was rated as poor when the adhesive force was less than 75 N.

(Wear Resistance)

As for the wear resistance, a cutting test was conducted under the following conditions by using a cutting tool (drill) having formed thereon a hard coating, and the maximum wear width of the substrate (carbide) exposed in a margin (near blade edge) after cutting of 160 holes was measured. The wear resistance was rated as good when the maximum wear width was 35 $\mu$m or less, and the wear resistance was rated as poor when the maximum wear width exceeded 35 $\mu$m.

[Cutting Test Conditions]

Workpiece: CFRP
Thickness: 5 mm
Drill: MEGA-DRILL-COMPOSITE-MD M2925-0600AU (diameter of drill: $\phi$6.00 mm), manufactured by MAPAL
Cutting speed: 45 m/min.
Table feed rate: 478 mm/min
Rotational speed: 2,389 rpm
Feed per one revolution: 0.2 mm/rev
Drilling depth: 5 mm
Evaluation condition: Maximum wear depth in margin after cutting 160 holes

[Table 1]

| No. | | Underlying Layer (thickness: 0.5 μm) | | | | | Adhesion-Reinforcing Layer (thickness: 1.5 μm) | | | | | | | |
| --- | --- | --- | --- | --- | --- | --- | --- | --- | --- | --- | --- | --- | --- | --- |
| | | Composition (atomic ratio) | | | | Power Source | Layer A | | | | | | | |
| | | | | | | | Composition (atomic ratio) | | | Power Source | Thickness | | | Presence or Absence of Layers A (pair) in Predetermined Relationship |
| | | Ti | Al | C | N | | Si | C | N | | Minimum Thickness (nm) | Amount of Increase (nm) | Maximum Thickness (nm) | |
| | | 1-a | a | 1-k | k | | w | x | 1-x | | | | | |
| 1 | Comparative Example | 0.20 | 0.80 | 0.00 | 1.00 | AIP | 0.50 | 0.50 | 0.50 | UBMS | 0.1 | 0.15 | 32 | A |
| 2 | Example | 0.35 | 0.65 | 0.00 | 1.00 | AIP | 0.50 | 0.50 | 0.50 | UBMS | 0.1 | 0.15 | 30 | A |
| 3 | Example | 0.50 | 0.50 | 0.00 | 1.00 | AIP | 0.50 | 0.50 | 0.50 | UBMS | 0.1 | 0.15 | 29 | A |
| 4 | Example | 0.50 | 0.50 | 0.00 | 1.00 | AIP | 0.50 | 0.50 | 0.50 | DMS | 0.1 | 0.2 | 31 | A |
| 5 | Example | 0.70 | 0.30 | 0.00 | 1.00 | AIP | 0.50 | 0.50 | 0.50 | UBMS | 0.1 | 0.15 | 32 | A |
| 6 | Comparative Example | 0.80 | 0.20 | 0.00 | 1.00 | AIP | 0.50 | 0.50 | 0.50 | UBMS | 0.1 | 0.15 | 28 | A |
| 7 | Comparative Example | 0.35 | 0.65 | 0.60 | 0.40 | AIP | 0.50 | 0.50 | 0.50 | UBMS | 0.1 | 0.15 | 27 | A |
| 8 (*1) | Comparative Example | 0.50 | 0.50 | 0.00 | 1.00 | AIP | - | - | - | - | - | - | - | - |

| No. | | Adhesion-Reinforcing Layer (thickness: 1.5 μm) | | Hardness (GPa) | Adhesion (N) | Wear Resistance, Maximum Wear Width (μm) |
| --- | --- | --- | --- | --- | --- | --- |
| | | Layer B | | | | |
| | | Composition, Power Source | Thickness (nm) | | | |
| 1 | Comparative Example | Same as underlying layer | 18 | 21 | 69 | 63 |

EP 3 165 630 A1

13

| No. | | Adhesion-Reinforcing Layer (thickness: 1.5 μm) | | Hardness (GPa) | Adhesion (N) | Wear Resistance, Maximum Wear Width (μm) |
|-----|---|-----|-----|-----|-----|-----|
| | | Layer B | | | | |
| | | Composition, Power Source | Thickness (nm) | | | |
| 2 | Example | Same as underlying layer | 19 | 32 | 84 | 21 |
| 3 | Example | Same as underlying layer | 20 | 33 | 85 | 18 |
| 4 | Example | Same as underlying layer | 20 | 37 | 91 | 14 |
| 5 | Example | Same as underlying layer | 18 | 35 | 90 | 15 |
| 6 | Comparative Example | Same as underlying layer | 20 | 22 | 68 | 58 |
| 7 | Comparative Example | Same as underlying layer | 20 | 16 | 43 | 77 |
| 8 (*1) | Comparative Example | - | - | 27 | 94 | 48 |
| (*1) A coating with a composition recited as the underlying layer was formed to a thickness of 2.0 μm. | | | | | | |

EP 3 165 630 A1

14

[Table 2]

| No. | | Underlying Layer (thickness: 0.5 μm) | | | | | Adhesion-Reinforcing Layer (thickness: 1.5 μm) | | | | | | | | |
| --- | --- | --- | --- | --- | --- | --- | --- | --- | --- | --- | --- | --- | --- | --- |
| | | Composition (atomic ratio) | | | | Power Source | Layer A | | | | | | | |
| | | | | | | | Composition (atomic ratio) | | | Power Source | Thickness | | | Presence or Absence of Layers A (pair) in Predetermined Relationship |
| | | Al | Cr | C | N | | Si | C | N | | Minimum Thickness (nm) | Amount of Increase (nm) | Maximum Thicknesss (nm) | |
| | | b | 1-b | 1-k | k | | w | x | 1-x | | | | | |
| 9 | Comparative Example | 0.10 | 0.90 | 0.00 | 1.00 | AIP | 0.50 | 0.50 | 0.50 | UBMS | 0.1 | 0.15 | 29 | A |
| 10 | Example | 0.30 | 0.70 | 0.00 | 1.00 | AIP | 0.50 | 0.50 | 0.50 | UBMS | 0.1 | 0.15 | 31 | A |
| 11 | Example | 0.50 | 0.50 | 0.00 | 1.00 | AIP | 0.50 | 0.50 | 0.50 | UBMS | 0.1 | 0.15 | 26 | A |
| 12 | Example | 0.50 | 0.50 | 0.00 | 1.00 | AIP | 0.50 | 0.50 | 0.50 | DMS | 0.1 | 0.15 | 32 | A |
| 13 | Example | 0.65 | 0.35 | 0.00 | 1.00 | AIP | 0.50 | 0.50 | 0.50 | UBMS | 0.1 | 0.15 | 17 | A |
| 14 | Example | 0.65 | 0.35 | 0.00 | 1.00 | AIP | 0.50 | 0.50 | 0.50 | UBMS | 0.1 | 0.15 | 24 | A |
| 15 | Example | 0.65 | 0.35 | 0.00 | 1.00 | AIP | 0.50 | 0.50 | 0.50 | DMS | 0.1 | 0.2 | 29 | A |
| 16 | Comparative Example | 0.65 | 0.35 | 0.00 | 1.00 | AIP | 0.50 | 0.50 | 0.50 | UBMS | 0.1 | 0.15 | 12 | A |
| 17 | Example | 0.65 | 0.35 | 0.00 | 1.00 | AIP | 0.40 | 0.60 | 0.40 | UBMS | 0.1 | 0.15 | 42 | A |
| 18 | Example | 0.65 | 0.35 | 0.00 | 1.00 | AIP | 0.60 | 0.50 | 0.50 | UBMS | 0.1 | 0.15 | 32 | A |
| 19 | Comparative Example | 0.65 | 0.35 | 0.00 | 1.00 | AIP | 0.25 | 0.50 | 0.50 | UBMS | 0.1 | 0.15 | 31 | A |
| 20 | Comparative Example | 0.65 | 0.35 | 0.00 | 1.00 | AIP | 0.50 | 0.90 | 0.10 | UBMS | 0.1 | 0.15 | 30 | A |
| 21 | Example | 0.75 | 0.25 | 0.00 | 1.00 | AIP | 0.50 | 0.50 | 0.50 | UBMS | 0.1 | 0.15 | 32 | A |
| 22 | Comparative Example | 0.85 | 0.15 | 0.00 | 1.00 | AIP | 0.50 | 0.50 | 0.50 | UBMS | 0.1 | 0.15 | 30 | A |
| 23 | Comparative Example | 0.65 | 0.35 | 0.80 | 0.20 | AIP | 0.50 | 0.50 | 0.50 | UBMS | 0.1 | 0.15 | 29 | A |

EP 3 165 630 A1

(continued)

| No. | | Underlying Layer (thickness: 0.5 $\mu$m) | | | | | Adhesion-Reinforcing Layer (thickness: 1.5 $\mu$m) | | | | | | | | |
| --- | --- | --- | --- | --- | --- | --- | --- | --- | --- | --- | --- | --- | --- | --- | --- |
| | | Composition (atomic ratio) | | | | Power Source | Layer A | | | | | | | | |
| | | | | | | | Composition (atomic ratio) | | | Power Source | Thickness | | | | Presence or Absence of Layers A (pair) in Predetermined Relationship |
| | | Al | Cr | C | N | | Si | C | N | | Minimum Thickness (nm) | Amount of Increase (nm) | Maximum Thicknesss (nm) | | |
| | | b | 1-b | 1-k | k | | w | x | 1-x | | | | | | |
| 24(*2) | Comparative Example | 0.65 | 0.35 | 0.00 | 1.00 | AIP | - | - | - | - | - | - | - | | - |
| 25 | Comparative Example | 0.65 | 0.35 | 0.00 | 1.00 | AIP | 0.50 | 0.50 | 0.50 | UBMS | 1.5 $\mu$m(*3) | | | | - |

| No. | | Adhesion-Reinforcing Layer (thickness: 1.5 $\mu$m) | | Hardness (GPa) | Adhesion (N) | Wear Resistance, Maximum Wear Width ($\mu$m) |
| --- | --- | --- | --- | --- | --- | --- |
| | | B layer | | | | |
| | | Composition, Power Source | Thickness (nm) | | | |
| 9 | Comparative Example | Same as underlying layer | 21 | 23 | 54 | 83 |
| 10 | Example | Same as underlying layer | 20 | 32 | 89 | 22 |
| 11 | Example | Same as underlying layer | 20 | 35 | 86 | 18 |
| 12 | Example | Same as underlying layer | 18 | 41 | 91 | 15 |

(continued)

| No. | Adhesion-Reinforcing Layer (thickness: 1.5 μm) B layer Composition, Power Source | Thickness (nm) | Hardness (GPa) | Adhesion (N) | Wear Resistance, Maximum Wear Width (μm) |
|---|---|---|---|---|---|
| 13 | Example | Same as underlying layer | 22 | 32 | 81 | 24 |
| 14 | Example | Same as underlying layer | 19 | 35 | 86 | 14 |
| 15 | Example | Same as underlying layer | 21 | 40 | 92 | 12 |
| 16 | Comparative Example | Same as underlying layer | 19 | 27 | 74 | 31 |
| 17 | Example | Same as underlying layer | 20 | 37 | 83 | 12 |
| 18 | Example | Same as underlying layer | 22 | 32 | 88 | 16 |
| 19 | Comparative Example | Same as underlying layer | 20 | 25 | 47 | 37 |
| 20 | Comparative Example | Same as underlying layer | 20 | 38 | 26 | 50 |
| 21 | Example | Same as underlying layer | 18 | 40 | 89 | 14 |

(continued)

| No. | | Adhesion-Reinforcing Layer (thickness: 1.5 μm) | | Hardness (GPa) | Adhesion (N) | Wear Resistance, Maximum Wear Width (μm) |
|---|---|---|---|---|---|---|
| | | B layer | | | | |
| | | Composition, Power Source | Thickness (nm) | | | |
| 22 | Comparative Example | Same as underlying layer | 19 | 27 | 62 | 84 |
| 23 | Comparative Example | Same as underlying layer | 20 | 21 | 32 | 92 |
| 24(*2) | Comparative Example | - | - | 27 | 92 | 32 |
| 25 | Comparative Example | - | - | 43 | 15 | 48 |

(*2) A coating with a composition recited as the underlying layer was deposited to a thickness of 2.0 μm.
(*3) An adhesion-reinforcing layer was not stacked, and only the layer A was deposited.

[Table 3]

| No. | | Underlying Layer (thickness: 0.5 μm) | | | | | | | Adhesion-Reinforcing Layer (thickness: 1.5 μm) | | | | | | | |
| | | Composition (atomic ratio) | | | | | | Power Source | Layer A | | | | | | | |
| | | | | | | | | | Composition (atomic ratio) | | | Power Source | Thickness | | | Presence or Absence of Layers A (pair) in Predetermined Relationship |
| | | Ti | Cr | Al | Si | C | N | | Si | C | N | | Minimum Thickness (nm) | Amount of Increase (nm) | Maximum Thickness (nm) | |
| | | 1-c-d-e | c | d | e | 1-k | k | | w | x | 1-x | | | | | |
| 26 | Comparative Example | 0.30 | 0.40 | 0.30 | 0.00 | 0.00 | 1.00 | AIP | 0.50 | 0.50 | 0.50 | UBMS | 0.1 | 0.15 | 35 | A |
| 27 | Example | 0.30 | 0.30 | 0.40 | 0.00 | 0.00 | 1.00 | AIP | 0.50 | 0.50 | 0.50 | UBMS | 0.1 | 0.15 | 31 | A |
| 28 | Example | 0.20 | 0.30 | 0.50 | 0.00 | 0.00 | 1.00 | AIP | 0.50 | 0.50 | 0.50 | UBMS | 0.1 | 0.15 | 28 | A |
| 29 | Example | 0.10 | 0.20 | 0.60 | 0.10 | 0.00 | 1.00 | AIP | 0.50 | 0.50 | 0.50 | UBMS | 0.1 | 0.15 | 29 | A |
| 30 | Example | 0.10 | 0.20 | 0.60 | 0.10 | 0.20 | 0.80 | AIP | 0.50 | 0.50 | 0.50 | UBMS | 0.1 | 0.15 | 30 | A |
| 31 | Example | 0.10 | 0.20 | 0.60 | 0.10 | 0.20 | 0.80 | AIP | 0.50 | 0.50 | 0.50 | DMS | 0.15 | 0.2 | 26 | A |
| 32 | Example | 0.00 | 0.10 | 0.65 | 0.25 | 0.00 | 1.00 | AIP | 0.50 | 0.50 | 0.50 | UBMS | 0.1 | 0.15 | 32 | A |
| 33 | Comparative Example | 0.20 | 0.20 | 0.20 | 0.40 | 0.00 | 1.00 | AIP | 0.50 | 0.50 | 0.50 | UBMS | 0.1 | 0.15 | 33 | A |
| 34 | Comparative Example | 0.00 | 0.00 | 0.80 | 0.20 | 0.00 | 1.00 | AIP | 0.50 | 0.50 | 0.50 | UBMS | 0.1 | 0.15 | 37 | A |
| 35(*4) | Comparative Example | 0.10 | 0.20 | 0.60 | 0.10 | 0.00 | 1.00 | AIP | - | - | - | - | - | - | - | - |

EP 3 165 630 A1

| No. | | Adhesion-Reinforcing Layer (thickness: 1.5 $\mu$m) | | Hardness (GPa) | Adhesion (N) | Wear Resistance, Maximum Wear Width ($\mu$m) |
|---|---|---|---|---|---|---|
| | | Layer B | | | | |
| | | Composition, Power Source | Thickness (nm) | | | |
| 26 | Comparative Example | Same as underlying layer | 19 | 29 | 71 | 69 |
| 27 | Example | Same as underlying layer | 21 | 35 | 85 | 16 |
| 28 | Example | Same as underlying layer | 20 | 36 | 84 | 15 |
| 29 | Example | Same as underlying layer | 18 | 38 | 87 | 16 |
| 30 | Example | Same as underlying layer | 23 | 39 | 89 | 15 |
| 31 | Example | Same as underlying layer | 22 | 42 | 92 | 11 |
| 32 | Example | Same as underlying layer | 21 | 38 | 84 | 13 |
| 33 | Comparative Example | Same as underlying layer | 18 | 31 | 57 | 54 |
| 34 | Comparative Example | Same as underlying layer | 19 | 24 | 63 | 80 |
| 35(*4) | Comparative Example | - | - | 29 | 95 | 31 |
| (*4) A coating with a composition recited as the underlying layer was deposited to a thickness of 2.0 $\mu$m. | | | | | | |

[Table 4]

| No. | | Underlying Layer (thickness: 0.5 μm) | | | | | Adhesion-Reinforcing Layer (thickness: 1.5 μm) | | | | | | | | |
|---|---|---|---|---|---|---|---|---|---|---|---|---|---|---|---|
| | | Composition (atomic ratio) | | | | Power Source | Layer A | | | | | | | | |
| | | | | | | | Composition (atomic ratio) | | | Power Source | Thickness | | | Presence or Absence of Layers A (pair) in Predetermined Relationship |
| | | Ti | Si | C | N | | Si | C | N | | Minimum Thickness (nm) | Amount of Increase (nm) | Maximum Thickness (nm) | |
| | | 1-f | f | 1-k | k | | w | x | 1-x | | | | | |
| 36 | Comparative Example | 1.00 | 0.00 | 0.00 | 1.00 | AIP | 0.50 | 0.50 | 0.50 | UBMS | 0.1 | 0.15 | 33 | A |
| 37 | Example | 0.95 | 0.05 | 0.00 | 1.00 | AIP | 0.50 | 0.50 | 0.50 | UBMS | 0.1 | 0.15 | 31 | A |
| 38 | Example | 0.85 | 0.15 | 0.00 | 1.00 | AIP | 0.50 | 0.50 | 0.50 | UBMS | 0.1 | 0.15 | 32 | A |
| 39 | Example | 0.85 | 0.15 | 0.00 | 1.00 | AIP | 0.50 | 0.50 | 0.50 | DMS | 0.1 | 0.15 | 32 | A |
| 40 | Example | 0.75 | 0.25 | 0.00 | 1.00 | AIP | 0.50 | 0.50 | 0.50 | UBMS | 0.1 | 0.15 | 29 | A |
| 41 | Comparative Example | 0.65 | 0.35 | 0.00 | 1.00 | AIP | 0.50 | 0.50 | 0.50 | UBMS | 0.1 | 0.15 | 30 | A |
| 42 | Comparative Example | 0.85 | 0.15 | 0.00 | 1.00 | AIP | - | - | - | - | - | - | - | - |
| 43(*5) | Comparative Example | - | - | - | - | - | 0.50 | 0.50 | 0.50 | DMS | - | - | - | - |

| No. | | Adhesion-Reinforcing Layer (thickness: 1.5 μm) | | Hardness (GPa) | Adhesion (N) | Wear Resistance, Maximum Wear Width (μm) |
|---|---|---|---|---|---|---|
| | | B layer | | | | |
| | | Composition, Power Source | Thickness (nm) | | | |
| 36 | Comparative Example | Same as underlying layer | 20 | 31 | 69 | 103 |

EP 3 165 630 A1

(continued)

| No. | | Adhesion-Reinforcing Layer (thickness: 1.5 μm) | | Hardness (GPa) | Adhesion (N) | Wear Resistance, Maximum Wear Width (μm) |
| --- | --- | --- | --- | --- | --- | --- |
| | | B layer | | | | |
| | | Composition, Power Source | Thickness (nm) | | | |
| 37 | Example | Same as underlying layer | 22 | 36 | 81 | 21 |
| 38 | Example | Same as underlying layer | 17 | 35 | 86 | 18 |
| 39 | Example | Same as underlying layer | 18 | 38 | 89 | 14 |
| 40 | Example | Same as underlying layer | 21 | 34 | 84 | 16 |
| 41 | Comparative Example | Same as underlying layer | 20 | 32 | 72 | 56 |
| 42 | Comparative Example | - | - | 24 | 91 | 53 |
| 43(*5) | Comparative Example | - | - | 41 | 16 | 87 |

(*5) A coating with a composition recited as the layer A was deposited to a thickness of 2.0 μm.

As shown in Table 1, in Nos. 2 to 5 (Examples) where the hard coating satisfies the requirements of the present invention, the hardness, adhesion and wear resistance were good.

On the other hand, in No. 1 (Comparative Example) where Ti in the underlying layer and the layer B was less than the lower limit value and Al exceeded the upper limit value, the hardness, adhesion and wear resistance were poor. In No. 6 (Comparative Example) where Ti in the underlying layer and the layer B exceeded the upper limit value and Al was less than the lower limit value, the hardness, adhesion and wear resistance were poor. In No. 7 (Comparative Example) where C in the underlying layer and the layer B exceeded the upper limit value and N was less than the lower limit value, the hardness, adhesion and wear resistance were poor. In No. 8 (Comparative Example) where the hard coating was composed of only an underlying layer, the hardness and wear resistance were poor.

As shown in Table 2, in Nos. 10 to 15, 17, 18 and 21 (Examples) where the hard coating satisfies the requirements of the present invention, the hardness, adhesion and wear resistance were good.

On the other hand, in No. 9 (Comparative Example) where Al in the underlying layer and the layer B was less than the lower limit value and Cr exceeded the upper limit value, the hardness, adhesion and wear resistance were poor. In No. 16 (Comparative Example) where the maximum thickness of the layer A was less than the lower limit value, the hardness and adhesion were poor. In No. 19 (Comparative Example) where Si in the layer A was less than the lower limit value, the hardness, adhesion and wear resistance were poor. In No. 20 (Comparative Example) where C in the layer A exceeded the upper limit value and N was less than the lower limit value, the adhesion and wear resistance were poor. In No. 22 (Comparative Example) where Al in the underlying layer and the layer B exceeded the upper limit value and Cr was less than the lower limit value, the hardness, the adhesion and wear resistance were poor. In No. 23 (Comparative Example) where C in the underlying layer and the layer B exceeded the upper limit value and N was less than the lower limit value, the hardness, adhesion and wear resistance were poor. In No. 24 (Comparative Example) where the hard coating was composed of only an underlying layer, the hardness was poor. In No. 25 (Comparative Example) where the adhesion-reinforcing layer was composed of only the layer A, the adhesion and wear resistance were poor.

As shown in Table 3, in Nos. 27 to 32 (Examples) where the hard coating satisfies the requirements of the present invention, the hardness, adhesion and wear resistance were good.

On the other hand, in No. 26 (Comparative Example) where Cr in the underlying layer and the layer B exceeded the upper limit value, the hardness, adhesion and wear resistance were poor. In No. 33 (Comparative Example) where Si in the underlying layer and the layer B exceeded the upper limit value, the adhesion and wear resistance were poor. In No. 34 (Comparative Example) where Al in the underlying layer and the layer B exceeded the upper limit value, the hardness, adhesion and wear resistance were poor. In No. 35 (Comparative Example) where the hard coating was composed of only an underlying layer, the hardness was poor.

As shown in Table 4, in Nos. 37 to 40 (Examples) where the hard coating satisfies the requirements of the present invention, the hardness, adhesion and wear resistance were good.

On the other hand, in No. 36 (Comparative Example) where Ti in the underlying layer and the layer B exceeded the upper limit value and Si was less than the lower limit value, the adhesion and wear resistance were poor. In No. 41 (Comparative Example) where Ti in the underlying layer and the layer B was less than the lower limit value and Si exceeded the upper limit value, the adhesion and wear resistance were poor. In No. 42 (Comparative Example) where an adhesion-reinforcing layer was not provided, the hardness and wear resistance were poor. In No. 43 (Comparative Example) where the hard coating was composed of only the layer A, the adhesion and wear resistance were poor.

<Second Example>

In Second Example, a test was performed by forming a layer C on the adhesion-reinforcing layer and changing the thickness of the layer C. Here, the coating composition and thickness of each of the underlying layer and the adhesion-reinforcing layer were fixed. After depositing the underlying layer to 0.5 μm, out of the adhesion-reinforcing layer, a layer A and a layer B were stacked to 20 nm, and the thickness of the layer A was increased from 0.1 nm (thickness of the lowermost layer) to a maximum thickness of 30 nm (thickness of the uppermost layer) so that an adhesion-reinforcing layer could be deposited to 1.5 μm. Thereafter, a layer C was deposited to the thickness shown in Table 5. The effect of the thickness of the layer C on the hardness, adhesion and wear resistance was studied.

Specifically, an underlying layer and an adhesion-reinforcing layer were formed on a substrate in the same manner as in First Example. Next, an SiC target (target diameter: 152.4 mmφ) as the layer C target was attached to the sputtering evaporation source. By rotating the substrate stage at a rotational speed of 5 rpm and applying a bias voltage -75 V to the substrate, the SiC target was evaporated to form a layer C with a predetermined thickness. For the layer A deposition and the layer C deposition, a UBMS power source or a DMS power source was used.

After the completion of deposition, the component composition in the hard coating was measured, and the hardness, adhesion and wear resistance were evaluated. The results obtained are shown in Table 5. The measuring method of component composition and the evaluation methods of hardness, adhesion and wear resistance were the same as in First Example. Out of the component compositions in the hard coating, the underlying layer and the layer B were "$Al_{0.65}Cr_{0.35}N$", the layer A was "$Si_{0.5}(C_{0.5}N_{0.5})_{0.5}$", and the layer C was "SiC".

[Table 5]

| No. | | Layer A | | Underlying Layer, Layer B | Layer C | | | Hardness (GPa) | Adhesion (N) | Wear Resistance, Maximum Wear Width (μM) |
|---|---|---|---|---|---|---|---|---|---|---|
| | | Composition (atomic ratio) | Power Source | Composition (atomic ratio) | Composition | Thickness (μm) | Power Source | | | |
| 44 | Comparative Example | $Si_{0.5}(C_{0.5}N_{0.5})_{0.5}$ | UBMS | $Al_{0.65}Cr_{0.35}N$ | SiC | 0.1 | UBMS | 35 | 93 | 38 |
| 45 | Example | $Si_{0.5}(C_{0.5}N_{0.5})_{0.5}$ | UBMS | $Al_{0.65}Cr_{0.35}N$ | SiC | 0.25 | UBMS | 37 | 94 | 19 |
| 46 | Example | $Si_{0.5}(C_{0.5}N_{0.5})_{0.5}$ | UBMS | $Al_{0.65}Cr_{0.35}N$ | SiC | 0.5 | UBMS | 38 | 94 | 12 |
| 47 | Example | $Si_{0.5}(C_{0.5}N_{0.5})_{0.5}$ | UBMS | $Al_{0.65}Cr_{0.35}N$ | SiC | 1 | UBMS | 40 | 92 | 12 |
| 48 | Example | $Si_{0.5}(C_{0.5}N_{0.5})_{0.5}$ | DMS | $Al_{0.65}Cr_{0.35}N$ | SiC | 1 | DMS | 42 | 95 | 9 |
| 49 | Example | $Si_{0.5}(C_{0.5}N_{0.5})_{0.5}$ | UBMS | $Al_{0.65}Cr_{0.35}N$ | SiC | 2 | UBMS | 39 | 89 | 10 |
| 50 | Example | $Si_{0.5}(C_{0.5}N_{0.5})_{0.5}$ | UBMS | $Al_{0.65}Cr_{0.35}N$ | SiC | 3 | UBMS | 40 | 88 | 11 |
| 51 | Example | $Si_{0.5}(C_{0.5}\ N_{0.5})_{0.5}$ | DMS | $Al_{0.65}Cr_{0.35}N$ | SiC | 3 | DMS | 45 | 92 | 8 |
| 52 | Example | $Si_{0.5}(C_{0.5}N_{0.5})_{0.5}$ | UBMS | $Al_{0.65}Cr_{0.35}N$ | SiC | 4 | UBMS | 44 | 87 | 18 |
| 53 | Example | $Si_{0.5}(C_{0.5}N_{0.5})_{0.5}$ | UBMS | $Al_{0.65}Cr_{0.35}N$ | SiC | 5 | UBMS | 46 | 78 | 24 |
| 54 | Example | $Si_{0.5}(C_{0.5}N_{0.5})_{0.5}$ | UBMS | $Al_{0.65}Cr_{0.35}N$ | SiC | 5.5 | UBMS | 46 | 75 | 25 |
| 55 | Comparative Example | $Si_{0.5}C_{0.5}N_{0.5})_{0.5}$ | UBMS | $Al_{0.65}Cr_{0.35}N$ | SiC | 6 | UBMS | 47 | 51 | 32 |

As shown in Table 5, in Nos. 45 to 54 (Examples) where the hard coating satisfies the requirements of the present invention, the hardness, adhesion and wear resistance were good. On the other hand, in No. 44 (Comparative Example) where the thickness of the layer C was less than the lower limit value, sufficient wear resistance could not be ensured, and the wear width was increased, revealing poor wear resistance. In No. 55 where the thickness of the layer C exceeded the upper limit value, the internal stress was increased, and the adherence was poor.

While the invention has been described in detail and with reference to specific embodiments thereof, it will be apparent to one skilled in the art that various changes and modifications can be made therein without departing from the spirit and scope of the invention.

This application is based on Japanese Patent Application No. 2014-136030 filed on July 1, 2014, the contents of which are incorporated herein by reference.

INDUSTRIAL APPLICABILITY

The hard coating of the present invention has high hardness, is excellent in the adhesion to a substrate and also excellent in wear resistance and therefore, is useful as jigs and tools such as cutting tool and die, particularly, jigs and tools targeting a hard-to-cut material such as carbon fiber reinforced plastic product.

DESCRIPTION OF REFERENCE NUMERALS AND SIGNS

1, 1A:   Hard coating
2:   Underlying layer
3:   Adhesion-reinforcing layer
4:   Layer A
5:   Layer B
6:   Layer C
10:   Substrate
20:   Grain

**Claims**

1.   A hard coating to be formed on a substrate, the hard coating comprising:

a layer A having a composition of $Si_w(C_xN_{1-x})_{1-w}$ and satisfying

$$0.30 \leq w \leq 0.65,$$

and

$$0.3 \leq x \leq 0.7;$$

and
a layer B having a composition of any of $Ti_{1-a}Al_a(C_{1-k}N_k)$, $Al_bCr_{1-b}(C_{1-k}N_k)$, $Ti_{1-c-d-e}Cr_cAl_dSi_e(C_{1-k}N_k)$ and $Ti_{1-f}Si_f(C_{1-k}N_k)$ and satisfying

$$0.3 \leq a \leq 0.7,$$

$$0.3 \leq b \leq 0.8,$$

$$c \leq 0.3,$$

$$0.3 \leq d \leq 0.7,$$

$$0 \leq e \leq 0.3,$$

$$1-c-d-e \leq 0.3,$$

$$0.05 \leq f \leq 0.3,$$

and

$$0.5 \leq k \leq 1,$$

wherein an underlying layer composed of the layer B is formed on the substrate, and an adhesion-reinforcing layer in which the layer A and the layer B have been alternately and repeatedly stacked is formed on the underlying layer,
at least one pair of layers A adjoining each other through a layer B within the adhesion-reinforcing layer satisfy the relationship that the thickness of the layer A formed on the side farther from the underlying layer is larger than the thickness of the layer A formed on the side closer to the underlying layer, and
the maximum thickness of the layer A within the adhesion-reinforcing layer is 15 nm or more.

2.  The hard coating according to claim 1, wherein a layer C is further formed on the adhesion-reinforcing layer, the layer C has a composition of SiC, and the thickness of the layer C is 0.2 $\mu$m or more and 5.5 $\mu$m or less.

FIG. 1

FIG. 2

FIG. 3

FIG. 4

107: Bias Power Source
108: Sputtering Power Source
109: Arc Power Source
111: AC Power Source for Heating
112: DC Power Source for Electric Discharge

## INTERNATIONAL SEARCH REPORT

International application No.

PCT/JP2015/069068

A. CLASSIFICATION OF SUBJECT MATTER
*C23C14/06*(2006.01)i, *B23B27/14*(2006.01)i, *B23B51/00*(2006.01)i, *B23C5/16*(2006.01)i, *B32B9/00*(2006.01)i

According to International Patent Classification (IPC) or to both national classification and IPC

B. FIELDS SEARCHED

Minimum documentation searched (classification system followed by classification symbols)
C23C14/00-14/58, B23B27/14, B23B51/00, B23C5/16, B32B9/00

Documentation searched other than minimum documentation to the extent that such documents are included in the fields searched
Jitsuyo Shinan Koho          1922-1996   Jitsuyo Shinan Toroku Koho   1996-2015
Kokai Jitsuyo Shinan Koho    1971-2015   Toroku Jitsuyo Shinan Koho   1994-2015

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2013-124405 A  (Kobe Steel, Ltd.), 24 June 2013 (24.06.2013), claim 1; paragraph [0071] & US 2014/0363648 A1    & WO 2013/089254 A1 & EP 2792765 A1          & IL 233105 D & KR 10-2014-0090667 A   & CN 104126025 A | 1,2 |
| A | JP 2005-256080 A  (Kobe Steel, Ltd.), 22 September 2005 (22.09.2005), claim 1; paragraph [0103], No.19 & US 2005/0170162 A1    & DE 102005004402 A & KR 10-2006-0042924 A   & CN 1651596 A & HK 1109175 A | 1,2 |

☒  Further documents are listed in the continuation of Box C.          ☐  See patent family annex.

| | | |
|---|---|---|
| * | Special categories of cited documents: | |
| "A" | document defining the general state of the art which is not considered    to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |
| "T" | later document published after the international filing date or priority date and not in conflict with the application but cited to understand the principle or theory underlying the invention | |
| "X" | document of particular relevance; the claimed invention cannot be considered novel or cannot be considered to involve an inventive step when the document is taken alone | |
| "Y" | document of particular relevance; the claimed invention cannot be considered to involve an inventive step when the document is combined with one or more other such documents, such combination being obvious to a person skilled in the art | |
| "&" | document member of the same patent family | |

Date of the actual completion of the international search
  04 September 2015 (04.09.15)

Date of mailing of the international search report
  15 September 2015 (15.09.15)

Name and mailing address of the ISA/
  Japan Patent Office
  3-4-3,Kasumigaseki,Chiyoda-ku,
  Tokyo 100-8915,Japan

Authorized officer

Telephone No.

Form PCT/ISA/210 (second sheet) (July 2009)

**INTERNATIONAL SEARCH REPORT**

International application No.

PCT/JP2015/069068

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2007-111815 A  (Sumitomo Electric Hardmetal Corp.), 10 May 2007 (10.05.2007), claim 1; fig. 1 (Family: none) | 1,2 |
| A | JP 2011-83879 A  (Sumitomo Electric Hardmetal Corp.), 28 April 2011 (28.04.2011), claim 1; fig. 1 (Family: none) | 1,2 |
| A | JP 2-159374 A  (Ube Industries, Ltd.), 19 June 1990 (19.06.1990), fig. 5(c) (Family: none) | 1,2 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005060765 A
- JP 2012132035 A
- JP 2012152878 A
- JP 2013096004 A
- JP 2005256080 A
- JP 2014136030 A

**Non-patent literature cited in the description**

- **SAWA et al.** calibrating the indenter tip shape. *J. Mater. Res.*, 2001, vol. 16 (11), 3084